# EUROPÄISCHE PATENTANMELDUNG

(11) **EP 1 937 039 A1**
(43) Veröffentlichungstag der Anmeldung: **25.06.2008**
(21) Anmeldenummer: 07022347.4
(22) Anmeldetag: 17.11.2007
(51) Int. Cl.: H05K 1/00, H05K 1/02, H01Q 1/40, H01Q 1/24, H01Q 1/08, H01Q 1/38

(54) **Folienaufbau mit zumindest einer Antenne**

(30) Priorität: 18.12.2006 DE 202006019045 U
(71) Anmelder: Albea Kunstofftechnik GmbH, 77960 Seelbach (DE)
(72) Erfinder: Frattini, David, 77656 Offenburg (DE)
(74) Vertreter: Maucher, Wolfgang

(57) **Zusammenfassung**

Die Erfindung betrifft einen Folienaufbau (1) mit zumindest einer Antenne, welcher Folienaufbau (1) eine als Grundträger (2) bestimmte Folie aus verformbaren Material hat, auf die eine elektrisch leitfähige Lackschicht (3) in Antennenstruktur aufgetragen ist, wobei zwischen der als Grundträger (2) bestimmten Folie und der Lackschicht (3) in Antennenstruktur eine elastische Zwischenschicht (4) vorgesehen ist.

## Beschreibung

Die Erfindung betrifft einen Folienaufbau mit zumindest einer Antenne, welcher Folienaufbau eine als Grundträger bestimmte Folie aus verformbaren Material hat, auf die eine elektrisch leitfähige Lackschicht in Antennenstruktur aufgetragen ist.

Aus der US 6 396 444 B1 ist ein Verfahren zur Herstellung eines Gehäuseteiles bekannt, bei welchem zunächst in einem ersten Verfahrensschritt auf eine verformbare Trägerfolie eine Lackschicht aus elektrisch leitfähigem Tintenlack aufgedruckt wird, bevor dieser Folienaufbau in nachfolgenden Verfahrensschritten in eine Spritzgussform eingelegt und mit dem Kunststoff-Gehäuseteil hinterspritzt wird. Da die elektrisch leitfähige Lackschicht jedoch regelmäßig spröde ist, besteht die Gefahr, dass die in der Antennenstruktur auf die Trägerfolie aufgedruckte Lackschicht aufbricht und die elektrische Antennenstruktur unterbrochen wird, wenn dieser Folienaufbau beispielsweise beim Einlegen in die Spritzgussform verformt wird.

Es besteht daher insbesondere die Aufgabe, einen Folienaufbau der eingangs erwähnten Art zu schaffen, bei dem selbst beim Verformen ein Aufbrechen der spröden Lackschicht vermieden wird.

Die erfindungsgemäße Lösung dieser Aufgabe besteht bei dem Folienaufbau der eingangs erwähnten Art insbesondere darin, dass zwischen der als Grundträger bestimmten Folie und der Lackschicht in Antennenstruktur eine elastische Zwischenschicht vorgesehen ist.

Der erfindungsgemäße Folienaufbau weist zwischen der als Grundträger bestimmten Folie und der Lackschicht in Antennenstruktur eine elastische Zwischenschicht auf, die die Sprödigkeit der elektrisch leitfähigen Schicht zu kompensieren vermag. Da die elastische Zwischenschicht die Sprödigkeit der Lackschicht ausgleichen kann, wird ein Aufbrechen der Antennenstruktur wirkungsvoll verhindert.

Um den Folienaufbau gegen mechanische Beschädigungen und/oder gegen Kurzschlüsse seiner Lackschichten zu schützen, ist es zweckmäßig, wenn der den Grundträger, die elastische Zwischenschicht und die Lackschicht in Antennenstruktur aufweisende Folienaufbau eine nicht leitfähige Schutzschicht trägt.

Dabei wird die gute und funktionssichere Verformbarkeit des erfindungsgemäßen Folienaufbaus begünstigt, wenn auch die Schutzschicht verformbar ist.

Eine Weiterbildung von eigener schutzwürdiger Bedeutung sieht vor, dass der Folienaufbau zumindest eine weitere elektrisch leitfähige Lackschicht in Antennenstruktur trägt, und dass zwischen diesen Lackschichten in Antennenstruktur und vorzugsweise auch auf der dem Grundträger abgewandten Außenseite des Folienaufbaus jeweils eine nicht leitfähige Schutzschicht vorgesehen ist.

Vorteilhaft ist es, wenn die zumindest eine leitfähige Lackschicht in Antennenstruktur zum Zwecke der Kontaktierung zumindest in einem Teilbereich ihres Umfangrandes schutzschichtfrei ist und/oder wenn zumindest zwei elektrisch leitfähige Lackschichten verschiedene Antennenstrukturen haben.

Die einfache und kostengünstige Herstellung des erfindungsgemäßen Folienaufbaus wird begünstigt, wenn die Zwischenschicht die zumindest eine Lackschicht in Antennenstruktur und/oder die wenigstens eine Schutzschicht auf den Grundträger vorzugsweise im Siebdruckverfahren aufgedruckt sind.

Eine bevorzugtes Anwendungsbeispiel sieht vor, dass der Folienaufbau als In-Mold-Foiling in ein Kunststoff-Formteil eingespritzt ist.

Dabei ist es besonders zweckmäßig, wenn der sichtseitig angeordnete Grundträger aus einer durchsichtigen und/oder transparenten Folie hergestellt ist, und wenn die sichtseitig vorzugsweise durchscheinende Zwischenschicht als Dekorschicht ausgestaltet ist.

Ein weiteres Ausführungsbeispiel sieht vor, dass der Folienaufbau als In-Mold-Foiling mit einem Kunststoff-Formteil hinterspritzt ist.

Zusätzliche Ausgestaltungen der Erfindung sind in den weiteren Unteransprüchen aufgeführt. Nachstehend ist die Erfindung mit ihren wesentlichen Einzelheiten anhand der Zeichnungen noch näher erläutert.

Es zeigt:
- Fig. 1: das Grundschema eines Folienaufbaus, der eine Antennenstruktur trägt,
- Fig. 2: einen mehrlagigen Folienaufbau, der verschiedene Antennenstrukturen trägt,
- Fig. 3: einen mit Fig.1 vergleichbaren Folienaufbau, der im In-Mold-Verfahren in ein Kunststoff-Formteil eingespritzt ist, und
- Fig. 4: einen mit Fig.1 vergleichbaren Folienaufbau, der im In-Mold-Verfahren mit einem Kunststoff-Formteil hinterspritzt ist.

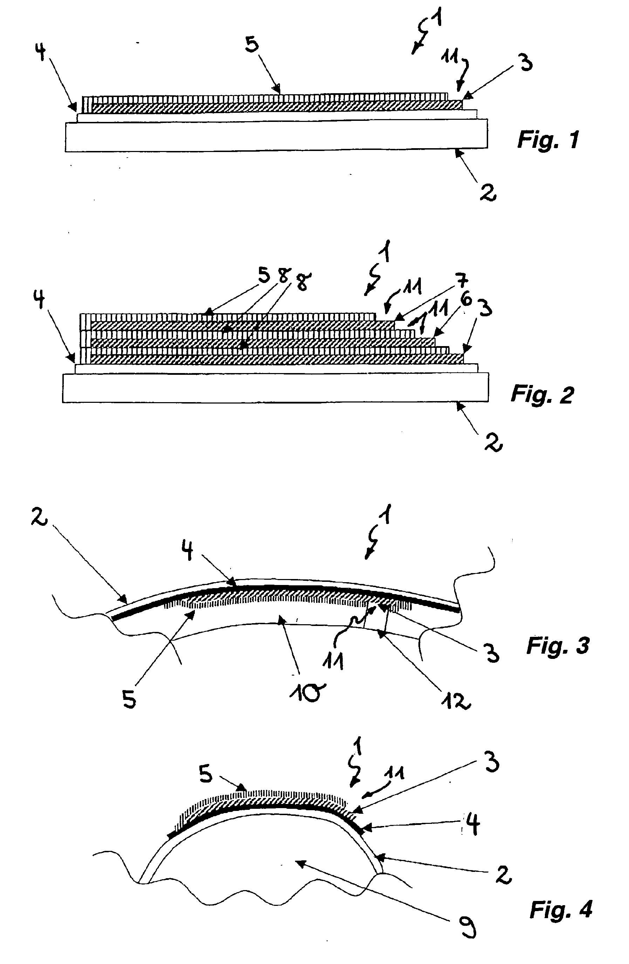

In den Fig.1 bis 4 sind verschiedene Ausführungen eines Folienaufbaus 1 dargestellt, der zumindest einer Antenne trägt. Der hier dargestellte Folienaufbau 1 ist über den Handybereich hinaus für alle Bauteile mit Antenneneinsatz, wie zum Beispiel Funkgeräte, WLAN-Systeme oder dergleichen, vorteilhaft einsetzbar. Auf die matte und entsprechend raue Seite einer als Grundträger 2 dienenden Folie aus verformbarem Material ist zumindest eine elektrisch leitfähige Lackschicht 3 in Antennenstruktur aufgetragen. Zwischen der als Grundträger 2 bestimmten Folie und der Lackschicht 3 in Antennenstruktur ist eine elastische Zwischenschicht 4 aufgetragen, welche die Sprödigkeit der elektrisch leitfähigen Schicht 3 zu kompensieren vermag. Da die elastische Zwischenschicht 4 die Sprödigkeit der Lackschicht 3 ausgleichen kann, wird ein Aufbrechen der Antennenstruktur beispielsweise beim Verformen und Einlegen des Folienaufbaus in eine Spritzgussform wirkungsvoll verhindert.

Aus den Fig.1 bis 4 wird deutlich, dass der den Grundträger 2, die elastische Zwischenschicht 4 und die Lackschicht 3 in Antennenstruktur aufweisende Folieaufbau 1 auf seiner den Grundträger 2 abgewandten Außenseite eine nicht leitfähige Schutzschicht 5 trägt, die den Folienaufbau 1 und seine Lackschichten in Antennenstruktur gegen mechanische Beschädigungen und/oder gegen Kurzschlüsse der Lackschicht schützen soll.

In Fig. 2 ist gezeigt, dass der Folienbau 1 auch in Multilayer-Technik hergestellt werden kann. Dabei weist der Folienaufbau 1 in Fig. 2 weitere elektrisch leitfähige Lackschichten 6,7 auf, die verschiedene Antennenstrukturen haben. Zwischen diesen Lackschichten ist ebenfalls jeweils eine Schutzschicht 8 vorgesehen, um eine Kontaktierung der verschiedenen Antennenstrukturen zu verhindern.

In Fig.3 ist dargestellt, dass der Folienaufbau 1 mit seiner als Lackschicht 3 aufgedruckten Antennenstruktur als In-Mold-Foiling in eine hier beispielsweise als Handy-Rückschale oder dergleichen Gehäuseteil ausgestaltetes Kunststoff-Formteil 10 eingespritzt werden kann. Dabei kann der sichtseitig angeordnete Grundträger 2 in Fig.3 aus einer durchsichtigen und/oder transparenten Folie hergestellt sein, so dass die sichtseitige und in diesem Ausführungsbeispiel vorzugsweise als Dekorschicht ausgestaltete Zwischenschicht 4 durchscheint.

Demgegenüber ist in Fig.4 gezeigt, dass der Folienaufbau 1 mit seiner aufgedruckten Antennenstruktur auch als In-Mold-Foiling mit einem Kunststoff-Formteil 9 hinterspritzt werden kann. Dabei dient der vorgespritzte Folienaufbau 1 als inneres Bauteil für das Kunststoff-Formteil 9.

Aus einem Vergleich der Fig.1 bis 4 ist zu erkennen, dass die Lackschichten 3,6 und 7 zum Zwecke der Kontaktierung zumindest in einem Teilbereich 11 ihres Umfangsrandes schutzschichtfrei sind. Dabei ist der in das Kunststoff-Formteil 10 eingespritzte Folienaufbau 1 in Fig. 3 durch einen Durchbruch 12 im Spritzgussteil zugänglich, um die Lackschichten dort kontaktieren zu können.

## Patentansprüche

1. Folienaufbau (1) mit zumindest einer Antenne, welcher Folienaufbau (1) eine als Grundträger (2) bestimmte Folie aus verformbaren Material hat, auf die eine elektrisch leitfähige Lackschicht (3) in Antennenstruktur aufgetragen ist, **dadurch gekennzeichnet, dass** zwischen der als Grundträger (2) bestimmten Folie und der Lackschicht (3) in Antennenstruktur eine elastische Zwischenschicht (4) vorgesehen ist.

2. Folienaufbau nach Anspruch 1, **dadurch gekennzeichnet, dass** der den Grundträger (2), die elastische Zwischenschicht (4) und die Lackschicht (3) in Antennenstruktur aufweisende Folienaufbau eine nicht leitfähige Schutzschicht (5) trägt.

3. Folienaufbau nach Anspruch 1 oder 2, **dadurch gekennzeichnet, dass** der Folienaufbau (1) zumindest eine weitere elektrisch leitfähige Lackschicht (6, 7) in Antennenstruktur trägt, und dass zwischen diesen Lackschichten (6, 7) in Antennenstruktur und vorzugsweise auch auf der dem Grundträger abgewandten Außenseite des Folienaufbaus jeweils eine nicht leitfähige Schutzschicht (5, 8) vorgesehen ist.

4. Folienaufbau nach einem der Ansprüche 1 bis 3, **dadurch gekennzeichnet, dass** die Schutzschicht(en) (5, 8) verformbar ist (sind).

5. Folienaufbau nach einem der Ansprüche 1 bis 4, **dadurch gekennzeichnet, dass** die zumindest eine leitfähige Lackschicht (3, 6, 7) in Antennenstruktur zum Zwecke der Kontaktierung zumindest in einem Teilbereich (12) ihres Umfangsrandes schutzschichtfrei ist.

6. Folienaufbau nach einem der Ansprüche 1 bis 5, **dadurch gekennzeichnet, dass** zumindest zwei elektrisch leitfähige Lackschichten (3, 6, 7) verschiedene Antennenstrukturen haben.

7. Folienaufbau nach einem der Ansprüche 1 bis 6, **dadurch gekennzeichnet, dass** die Zwischenschicht (4), die zumindest eine Lackschicht (3, 6, 7) in Antennenstruktur und/oder die wenigstens eine Schutzschicht (5, 8) auf den Grundträger (2) vorzugsweise im Siebdruckverfahren oder einem anderen geeigneten Verfahren aufgedruckt oder aufgebracht sind.

8. Folienaufbau nach einem der Ansprüche 1 bis 7, **dadurch gekennzeichnet, dass** der Folienaufbau (1) als In-Mold-Foiling in ein Kunststoff-Formteil (10) eingespritzt ist.

9. Folienaufbau nach Anspruch 8, **dadurch gekennzeichnet, dass** der sichtseitig angeordnete Grundträger (2) aus einer durchsichtigen und/oder transparenten Folie hergestellt ist, und dass die sichtseitig vorzugsweise durchscheinende Zwischenschicht (4) als Dekorschicht ausgestaltet ist.

10. Folienaufbau nach einem der Ansprüche 1 bis 7, **dadurch gekennzeichnet, dass** der Folienaufbau (1) als In-Mold-Foiling mit einem Kunststoff-Formteil (9) hinterspritzt ist.
